# EUROPEAN PATENT SPECIFICATION

(11) **EP 0 674 018 B1**
(45) Date of publication and mention of the grant of the patent: **16.06.1999**
(21) Application number: 95301973.4
(22) Date of filing: 24.03.1995
(51) Int. Cl.: C23C 16/00, C23C 16/04, B28B 3/20, B28B 3/26

(54) **Method of regenerating dies for extruding ceramic honeycomb structural bodies**
Verfahren zur Wiederherstellung von Formen zum Extrudieren keramischer Körper mit Honigwaben-Struktur
Procédé pour restaurer une matrice pour l'extrusion de corps à structure en nid d'abeilles en céramique

(30) Priority: 25.03.1994 JP 5543194
(43) Date of publication of application: 27.09.1995
(73) Proprietor: NGK INSULATORS, LTD., Nagoya City Aichi Pref. (JP)
(72) Inventor: Nakano, Kenji, Tokai City, Aichi Pref. (JP); Suzuki, Kazuo, Inazawa City, Aichi Pref. (JP)
(74) Representative: Paget, Hugh Charles Edward

(56) References cited:
- EP-A- 0 057 587
- EP-A- 0 389 253
- EP-A- 0 506 328

## Description

### Background of the Invention

The present invention relates to a method of regenerating dies for extruding ceramic honeycomb structural bodies, in which an abrasion-resistant coating layer is formed by a chemical vapor deposition method on a surface of a die member having extrusion slits and a plurality of holes for supplying a ceramic batch respectively communicated with the extrusion slits.

Heretofore, various kinds of dies have been known in which an abrasion-resistant coating layer is formed by a chemical vapor deposition method on a surface of a die member having extrusion slits and a plurality of holes for supplying a ceramic batch respectively communicated with the extrusion slits so as to define a width of respective slits. Hereinafter, such a die is referred to as a CVD die. Usually, the CVD dies are produced by forming a die member having extrusion slits with a slit width larger than that of a final CVD die and a plurality of holes for supplying a ceramic batch respectively communicated with the extrusion slits, setting the thus formed die member in a CVD apparatus, and forming an abrasion-resistant coating layer on a surface of the die member by a chemical vapor deposition method, thereby the width of the slit is set to that of the final CVD die.

As a method of producing the CVD die, the applicant proposed a method of treating two die members at the same time in Japanese Patent Laid-open Publication No. 3-281,306 (JP-A-3-281,306). Moreover, in US-A- 5,256,449, corresponding to EP-A-0 506 328, the applicant disclosed a method of treating a plurality of die members at the same time in a chemical vapor deposition operation while limiting a gas flow to be used for the chemical vapor deposition.

EP-A-0 389 253, filed in the name of the applicant, discloses the regeneration of a partially worn die in that no chemical vapor deposition is applied onto end faces of the material feed holes by masking them. In a further step, the vapor deposited layer is removed together with an underlying nickel layer by chemical dissolution.

In the CVD die using the die members mentioned above, if an extruding operation is continued by using the CVD die, the abrasion-resistant coating layer is gradually decreased, and thus the slit width of the extrusion slit cannot be maintained as it is. Therefore, the CVD die is regarded as worn out when an abrasive amount of the abrasion-resistant coating layer becomes larger than a predetermined value. In this case, it is not possible to further use the CVD die. However, since the CVD die is expensive, the CVD die is generally regenerated so as to recover the slit width of the extrusion slit. That is to say, abrasion-resistant materials are coated again on the abrasion-resistant coating layer by the chemical vapor deposition operation so as to recover the slit width to an initial level.

In this case, an abrasion degree due to a batch extruding operation is different as between a center portion and an outer peripheral portion of the CVD die. That is to say, in the center portion of the CVD die, since all the extrusion slits are used for generating cell walls of the ceramic honeycomb structural body, the ceramic batch is uniformly passed through the extrusion slits. Therefore, the abrasive amount of the abrasion-resistant coating layers is uniform at all the extrusion slits. On the other hand, in the outer peripheral portion of the CVD die, since a few outermost extrusion slits are used for generating an outer wall of the ceramic honeycomb structural body, the abrasive amount of the abrasion-resistant coating layers becomes extremely small as compared with that of the center portion.

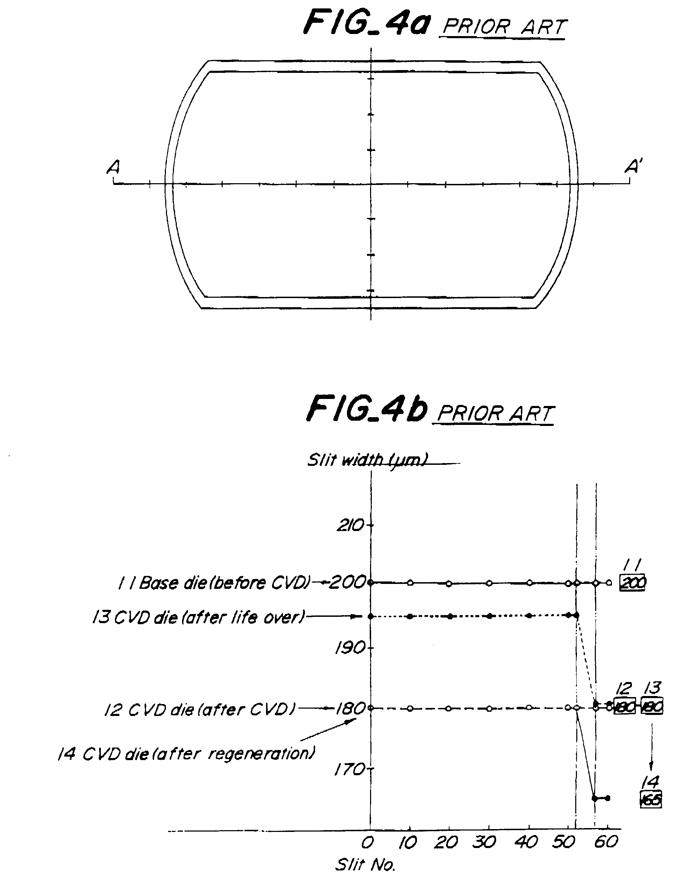

Fig. 4a is a schematic view showing a position of the extrusion slits, and Fig. 4b is a graph illustrating a relation on a cross section along an A-A' line in Fig. 4a between the position of the extrusion slits and the slit width. In Figs. 4a and 4b, a line represented by a numeral 11 shows a reference die member before the chemical vapor deposition operation. In this case, the slit width of the center portion (other than the outer peripheral portion) is 200 µm, and the slit width of the outer peripheral portion is also 200 µm. Then, as shown in a line represented by a numeral 12, the initial CVD die is obtained by forming the abrasion-resistant coating layer having a thickness of 10 µm by the chemical vapor deposition method. In this case, the slit width of the center portion is 180 µm, and the slit width of the outer peripheral portion is also 180 µm.

Then, a line represented by a numeral 13 shows the CVD die which reaches to a life alter the extruding operations. In this case, the slit width of the center portion is 195 µm, and the slit width of a part of the outer peripheral portion neighboring the center portion is also 195 µm. This shows a uniform abrasion. However, the slit width of the outermost peripheral portion is maintained at 180 µm, which shows no abrasion. Therefore, in order to regenerate the CVD die, if a uniform abrasion-resistant coating layer having a thickness of 7.5 µm is formed by the chemical vapor deposition operation on all the extrusion slits, a complete regeneration operation is performed to the extrusion slits in the center portion and in the part of the outer peripheral portion since the slit width of them recovers to 180 µm, but is not performed to the extrusion slits in the outermost peripheral portion since the slit width of them is 165 µm which is smaller than that of the initial CVD die.

As mentioned above, in order to regenerate the over-life CVD die in which the abrasive amount is different at between the center portion and the outermost peripheral portion, if a uniform abrasion-resistant coating layer is formed by the chemical deposition method with reference to the abrasive amount of the extrusion slits in the center portion, there occurs a drawback such that the slit width of the extrusion slits positioned in the outermost peripheral portion is extremely smaller than that of the initial outermost peripheral portion. As a result, if the ceramic honeycomb extruding operation is restarted by using the CVD die regenerated as mentioned above, various problems such as a coarse portion on the outer wall and so on occur.

### Summary of the Invention

It is an object of the present invention to eliminate the drawbacks mentioned above and to provide a method of regenerating dies for extruding ceramic honeycomb structural bodies in which the ceramic honeycomb structural body having no coarse portions on its outer wall can be obtained if use is made of the regenerated CVD die.

According to the invention, a method of regenerating dies for extruding ceramic honeycomb structural bodies is provided in claim 1.

In the method of the invention, the mask is arranged on the outer peripheral portion of the die at which the abrasion loss is small. Therefore, if a uniform abrasion-resistant coating layer is formed on the abrasion-resistant coating layers remaining on the extrusion slits by the CVD apparatus with reference to the abrasive amount of the extrusion-slits positioned at the center portion of the die so as to perform the regeneration of the CVD die, the abrasion-resistant coating layer is not formed so much on the abrasion-resistant coating layer remaining on the extrusion slits in the outer portion, and thus it is possible to regnerate the CVD die in which a uniform slit width of the extrusion slits is obtained both in the center portion and in the outer portion. As a result, if the ceramic honeycomb extruding operation is restarted by using the CVD die regenerated according to the present invention, there occurs no problems on the outer wall of the ceramic honeycomb structural bodies.

### Brief Description of the Drawings

Fig. 1 is a schematic view showing one embodiment of performing a method of regenerating dies for extruding ceramic honeycomb structural bodies according to the invention;
Figs. 2a to 2c are schematic views respectively illustrating one embodiment of a mask used for the die regenerating method according to the invention;
Fig. 3 is a graph for comparing a uniformity of the extrusion slits after a regenerating operation; and
Fig. 4a is a schematic view showing a position of the extrusion slits and Fig. 4b is a graph illustrating a relation on a cross section along an A-A' line in Fig. 4a between the position of the extrusion slits and the slit width according to the conventional method.

### Detailed Description of the Invention

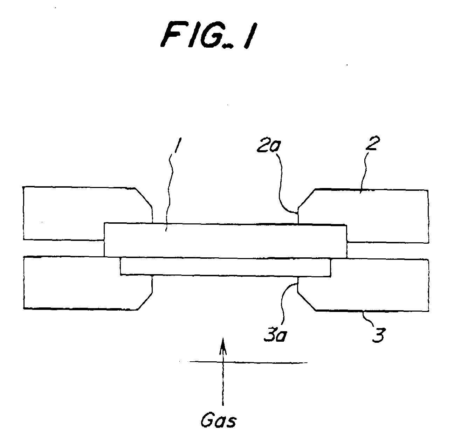

Fig. 1 is a schematic view showing one embodiment of performing a method of regenerating dies for extruding ceramic honeycomb structural bodies. In the embodiment shown in Fig. 1, a CVD die 1 to be regenerated which has reached its useful life end has a mask 2 arranged on a side of extrusion slits of the CVD die 1, and a mask 3 arranged on a side of holes for supplying a ceramic batch respectively communicated with the extrusion slits. Under the condition that outer peripheral portions of the CVD die 1 are sealed by the masks 2 and 3, the CVD die 1 is set in a chemical vapor deposition apparatus (hereinafter, referred to as CVD apparatus) and a gas is supplied in the CVD apparatus to perform a chemical vapor deposition method (hereinafter, referred to as CVD method), thereby a die regenerating operation is performed by forming an abrasion-resistant coating layer on a previous abrasion-resistant coating layer remaining on the extrusion slits. As for the CVD method, all the known CVD methods can be applied to the method according to the invention, but it is preferred to use the CVD method disclosed in JP-A-3-281,306 or USP 5,256,449.

In the embodiment mentioned above, it is important to define a position of end portions 2a and 3a of the masks 2 and 3 with respect to the CVD die 1. Usually, the present invention can be achieved if the masks 2 and 3 can seal the portions in which an abrasive amount is small i.e. the portions corresponding to the outermost peripheral portions in Fig. 4b in which no abrasion occurs even after a useful life. However, in the actual CVD method, if the extrusion slits of the CVD die 1 are sealed by the masks 2 and 3, the abrasion-resistant coating layer is formed a little to the extrusion slits neighboring the end portions 2a and 3a. Therefore, it is preferred to position the end portions 2a and 3a at a little inwardly from the outermost peripheral portions in which no abrasion occurs.

Moreover, as for a shape of the end portions 2a and 3a, the end portions 2a and 3a in Fig. 1 are vertical with respect to the CVD die 1, but they may be other shapes such as a slope tapered shape and so on. Further, in Fig. 1, the shapes of the end portions 2a and 3a are same. However, it is possible to make the end portion 3a positioned at an upstream side with respect to a gas flow for the chemical vapor deposition to a tapered shape, while the shape of the end portion 2a positioned at a downstream side is maintained vertical with respect to the CVD die 1.

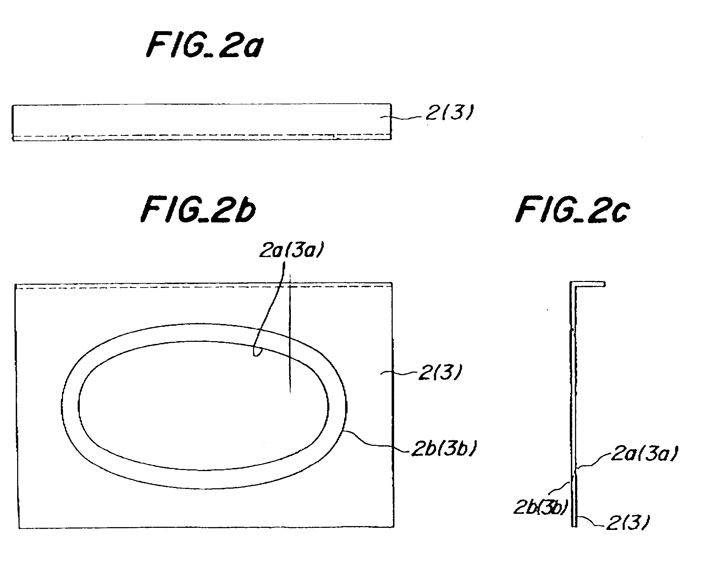

Fig. 2 is a schematic view showing one embodiment of the mask 2(3) used for the die regenerating method according to the invention. In Fig. 2, Fig. 2a shows a front view, Fig. 2b illustrates a plan view and Fig. 2c depicts a side view. In the embodiment shown in Fig. 2, the mask 2(3) is formed by an L-shaped thin plate made of graphite, and the end portion 2a(3a) and its outer portion 2b(3b) make a slope tapered shape. In this embodiment, a portion 2c(3c) of the mask 2(3) arranged vertically with respect to a mask plane can be used for positioning the mask 2(3) with respect to the CVD die.

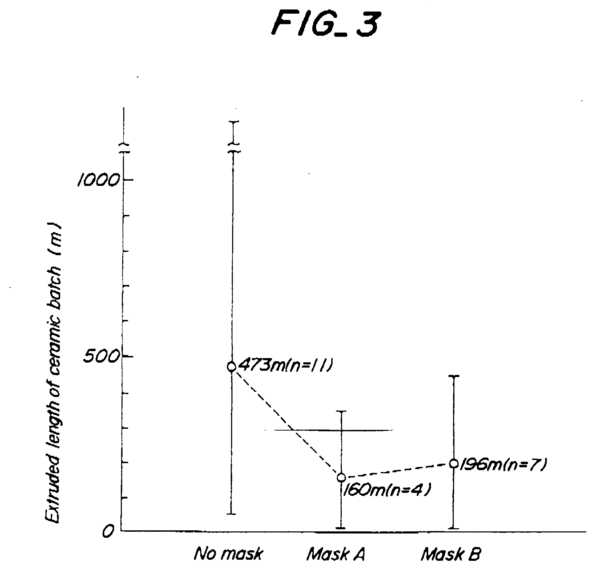

Usually, a finish correction of the regenerated CVD die is performed by actually extruding a ceramic batch by using the regenerated CVD die till the outer wall of the extruded honeycomb structural body becomes smooth i.e. not coarse. Therefore, a uniformity of the extrusion slits after the die regenerating is measured by a batch extruded length necessary for correcting the outer wall with respect to the CVD dies regenerated by using a mask A, using a mask B and using no mask. The measured results are shown in Fig. 3.

From the results shown in Fig. 3, the CVD die regenerated by using the mask A or mask B according to the invention needs a batch extruded length smaller than that of the CVD die regenerated by using no mask according to the conventional method. Therefore, it is understood that the uniformity of the extrusion slits of the CVD die according to the invention is better than that of the CVD die according to the conventional method, and thus the outer wall of the CVD die according to the invention is smooth as compared with that of the CVD die according to the conventional method.

As mentioned above, according to the invention, the mask is arranged at the outer portion of the CVD die in which an abrasive amount is small. Therefore, if a uniform abrasion-resistant coating layer is formed on the abrasion-resistant coating layer remaining on the extrusion slits by the CVD apparatus with reference to the abrasive amount of the extrusion slits positioned at the center portion of the CVD die so as to perform the regeneration of the CVD die, the abrasion-resistant coating layer is not formed so much on the abrasion-resistant coating layer remaining on the extrusion slits in the outer portion, and thus it is possible to regnerate the CVD die in which a uniform slit width of the extrusion slits is obtained both in the center portion and in the outer portion. Therefore, if the ceramic honeycomb extruding operation is restarted by using the CVD die regenerated according to the invention, it is possible to obtain the ceramic honeycomb structural body having the smooth outer wall.

## Claims

1. A method of regenerating a die member for extruding ceramic honeycomb structural bodies, in which method an abrasion-resistant coating layer is formed by chemical vapor deposition on surfaces of extrusion slits and ceramic feed holes, which communicate with the extrusion slits in the die member, the method comprising the steps of (i) arranging a mask (2,3) on an outer peripheral portion of at least one end face of said die member where the amount of abrasive loss of said abrasion-resistant coating layer during use is relatively small, and (ii) forming the abrasion-resistant coating layer by chemical vapor deposition on said surfaces of said die member.

2. The method according to claim 1, wherein said mask is made of graphite.

3. The method according to claim 1 or 2, wherein an inner edge portion of said mask is tapered.

4. The method according to claim 1 or 2, wherein an inner edge portion of said mask positioned at the upstream side of the die member with respect to the direction of chemical vapor deposition gas flow is tapered, and an inner edge portion of said mask positioned at the downstream side is perpendicular to the end face of said die member.

5. The method according to claim 1 or 2, wherein said mask has a portion arranged perpendicularly to the plane of the mask, which portion is used for positioning said mask with respect to said die.

## Patentansprüche

1. Verfahren zum Wiederinstandsetzen eines Düsenelements zum Extrudieren von Keramikwaben-Strukturkörpern, bei welchem Verfahren eine abriebbeständige Überzugsschicht durch chemische Dampfabscheidung auf Oberflächen von Extrusionsschlitzen und Keramikzufuhrlöchern ausgebildet wird, die mit den Extrusionsschlitzen im Düsenelement kommunizieren, wobei das Verfahren folgende Schritte umfaßt: (i) das Anordnen einer Maske (2, 3) an einem äußeren Peripherieabschnitt zumindest einer Endfläche des Düsenelements, an dem das Ausmaß an Abriebverlust der abriebbeständigen Überzugsschicht während der Verwendung relativ gering ist, und (ii) das Ausbilden der abriebbeständigen Überzugsschicht durch chemische Dampfabscheidung auf den Oberflächen des Düsenelements.

2. Verfahren nach Anspruch 1, worin die Maske aus Graphit besteht.

3. Verfahren nach Anspruch 1 oder 2, worin ein Innenkantenabschnitt der Maske verjüngt ist.

4. Verfahren nach Anspruch 1 oder 2, worin ein Innenkantenabschnitt der Maske, der sich in bezug auf die Richtung des Gasstroms der chemischen Dampfabscheidung auf der stromauf gelegenen Seite des Düsenelements befindet, verjüngt ist, und ein Innenkantenabschnitt der Maske, der sich auf der stromab gelegenen Seite befindet, zur Endfläche des Düsenelements rechtwinkelig verläuft.

5. Verfahren nach Anspruch 1 oder 2, worin die Maske einen Abschnitt aufweist, der rechtwinkelig zur Ebene der Maske verläuft, welcher Abschnitt zum Anordnen der Maske in bezug auf die Düse verwendet wird.

## Revendications

1. Procédé de restauration d'un élément de filière d'extrusion de corps en céramique à structure en nid d'abeille, procédé dans lequel une couche de revêtement résistant à l'abrasion est formée par dépôt chimique de vapeur sur la surface des fentes d'extrusion et des trous d'alimentation en céramique qui communiquent avec les fentes d'extrusion de l'élément de filière, le procédé comportant les étapes consistant à (i) agencer un masque (2, 3) sur une partie périphérique extérieure d'au moins une face d'extrémité dudit élément de filière, partie dans laquelle la quantité de perte par abrasion de ladite couche de revêtement résistant à l'abrasion est relativement faible en utilisation, et (ii) en formant la couche de revêtement résistant à l'abrasion par dépôt chimique de vapeur sur lesdites surfaces dudit élément de filière.

2. Procédé selon la revendication 1, dans lequel ledit masque est constitué de graphite.

3. Procédé selon la revendication 1 ou 2, dans lequel une partie de bord intérieur dudit masque est évasée.

4. Procédé selon la revendication 1 ou 2, dans lequel une partie de bord intérieur dudit masque, située à l'amont de l'élément de filière par rapport à la direction de l'écoulement du gaz de dépôt chimique de vapeur est évasée, et une partie de bord intérieur dudit masque, disposée du côté aval, est perpendiculaire à la face d'extrémité dudit élément de filière.

5. Procédé selon la revendication 1 ou 2, dans lequel ledit masque présente une partie agencée perpendiculairement au plan du masque, laquelle partie est utilisée pour positionner ledit masque par rapport à ladite filière.
